# EUROPEAN PATENT APPLICATION

(11) **EP 4 791 161 A1**
(43) Date of publication of application: **12.08.2026**
(21) Application number: 26157084.0
(22) Date of filing: 06.02.2026
(51) Int. Cl.: H10K 59/124, H10K 59/80, H10K 59/123, H10K 59/12

(54) **DISPLAY DEVICE AND METHOD OF MANUFACTURING THE SAME**

(30) Priority: 07.02.2025 KR 20250016140
(71) Applicant: Samsung Display Co., Ltd., Yongin-si, Gyeonggi-do 17113 (KR)
(72) Inventor: SHIM, Dong Hwan, 17113 Yongin-si (KR); KIM, Dong Uk, 17113 Yongin-si (KR); LEE, Hoon Gi, 17113 Yongin-si (KR); KIM, Hyun Ho, 17113 Yongin-si (KR)
(74) Representative: Taor, Simon Edward William

(57) **Abstract**

The display device includes a pixel defining layer that defines a pixel region; a light-emitting layer provided within the pixel region; a first electrode and a second electrode respectively under and an over the light-emitting layer; a reflective pattern under the first electrode; and an etching prevention pattern under the reflective pattern, wherein the etching prevention pattern may be electrically connected to the first electrode.

## Description

### BACKGROUND

### 1. Field

Embodiments of the present disclosure relate to a display device and a method of manufacturing the same, and, for example, to a display device which includes a light-emitting layer and a method of manufacturing the display device.

### 2. Description of the Related Art

An organic light-emitting device has self-luminous characteristics, and may provide improved viewing angles and contrast characteristics. In addition, the organic light-emitting device may provide high response speed and high brightness. A display device may have a plurality of pixels. The plurality of pixels may emit light of different colors.

A light-emitting layer and electrodes to drive the same are provided in a light-emitting region of a pixel. Recently, various suitable designs for the light-emitting region have been studied to improve the viewing angles, luminance ratio, and/or the like, of light emitted from the light-emitting layer.

### SUMMARY

According to an aspect of embodiments of the present disclosure, there is provided a display device having improved luminance uniformity.

According to an aspect of embodiments of the present disclosure, there is provided a display device having improved frontal luminance efficiency, viewing angles, and side luminance ratio.

According to an aspect of embodiments of the present disclosure, there is provided an electronic device which includes a display device having improved luminance uniformity, frontal luminance efficiency, viewing angles, and side luminance ratio.

A display device according to example embodiments may include: a pixel defining layer configured to define a pixel region; a light-emitting layer provided within the pixel region; a first electrode and a second electrode respectively under and over the light-emitting layer; a reflective pattern under the first electrode; and an etching prevention pattern under the reflective pattern, wherein the etching prevention pattern may be electrically connected to the first electrode.

In some embodiments, the etching prevention pattern may have the same potential (e.g., electrical potential) as the first electrode.

In some embodiments, the first electrode may be an anode and the second electrode may be a cathode.

In some embodiments, the reflective pattern may include a concave-convex shape having an upper surface and an inclined surface.

In some embodiments, the first electrode, the light-emitting layer and the second electrode may be provided in a shape corresponding to the shape of the reflective pattern.

In some embodiments, the etching prevention pattern may be integrally formed as a continuous structure.

In some embodiments, the etching prevention pattern may be electrically connected to the first electrode under the reflective pattern closest to the pixel defining layer.

In some embodiments, the etching prevention pattern may include a spiral-shaped pattern.

In some embodiments, the spiral-shaped pattern may have a structure in which semicircles having different diameters are alternately connected based on a spiral center.

In some embodiments, the spiral-shaped pattern may have a structure in which semicircles having progressively increasing diameters, starting from a semicircle having the smallest diameter at the spiral center, which serves as a spiral's starting point at one end, are alternately connected.

In some embodiments, a set or specific spiral pattern line and a spiral pattern line on an outside thereof may have a distance between center lines of the spiral pattern lines, which is greater than or equal to a pitch of the spiral pattern lines.

In some embodiments, among pairs of symmetry axes that pass through (or cross) the center of the spiral and are perpendicular (e.g., substantially perpendicular) to each other ("intersecting symmetry axes"), there may exist a pair of symmetry axes having the same number of pattern lines intersected by each of the intersecting symmetry axes.

In some embodiments, the etching prevention pattern may include a mesh-shaped pattern.

In some embodiments, the mesh-shaped pattern may have a contact region where openings face each other, and the contact regions are formed so that, among pairs of symmetry axes that pass through (or cross) a center of the mesh-shaped pattern and are perpendicular to each other ("intersecting symmetry axes"), there may exist a pair of symmetry axes having the same number of contact regions intersected by each of the intersecting symmetry axes.

A display device according to example embodiments may include: a light-emitting device and a transistor electrically connected to the light-emitting device,
wherein the light-emitting device may include: a pixel defining layer configured to define a pixel region; a light-emitting layer within the pixel region; a first electrode and a second electrode respectively under and over the light-emitting layer; a reflective pattern under the first electrode; and an etching prevention pattern under the reflective pattern, wherein the etching prevention pattern may be electrically connected to the first electrode, and
the transistor may include: an active layer, a gate insulation layer, a gate electrode and a connection electrode, wherein the first electrode and the etching prevention pattern may be electrically connected to the connection electrode.

In some embodiments, the etching prevention pattern may extend to a contact part of the first electrode and the connection electrode.

In some embodiments, the etching prevention pattern may be in contact with at least a part of the contact part of the first electrode and the connection electrode.

In some embodiments, the etching prevention pattern may be conductive (e.g., electrically conductive).

An electronic device according to example embodiments may include: the above-described display device; a window structure configured to provide a display surface of the display device; and a housing in which the display device is accommodated.

In some embodiments, the electronic device may include a flat panel display, a curved display, a computer monitor, a medical monitor, a television, a billboard, indoor and/or outdoor lighting, a signaling light, a head-up display, a transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a microdisplay, a 3D display, a virtual reality display, an augmented reality display, a vehicle, a video wall, a theater or stadium screen, and/or a light therapy device.

In the display device according to the embodiments of the present disclosure, the etching prevention pattern may be electrically connected to the first electrode. Accordingly, the parasitic capacitance caused by the etching prevention pattern may be eliminated or reduced, thereby improving the light-emission uniformity.

The etching prevention pattern may have a symmetrical structure. For example, the etching prevention pattern may have at least one axis of symmetry. Accordingly, the light-emission uniformity may be improved.

A reflective pattern may be over the etching prevention pattern. Accordingly, the frontal luminance efficiency may be improved, and the viewing angles and the side luminance ratio (color difference) may also be enhanced.

According to an aspect, there is provided a display device as set out in claim 1. Additional features are set out in claims 2 to 10. According to aspect, there is provided a display device as set out in claim 11. Additional features are set out in claims 12 to 13. According to aspect, there is provided an electronic device as set out in claim 14. Additional features are set out in claim 15.

### BRIEF DESCRIPTION OF THE DRAWINGS

The above and other objects and features of embodiments of the present disclosure will be more clearly understood from the following detailed description taken in conjunction with the accompanying drawings, in which:
FIG. 1 is a schematic cross-sectional view illustrating a display device according to example embodiments;
FIG. 2 is a partially enlarged cross-sectional view of region B in FIG. 1;
FIG. 3 is a partially enlarged cross-sectional view illustrating a display device according to a comparative example;
FIG. 4 is a schematic plan view illustrating an etching prevention pattern according to the comparative example;
FIGS. 5A to 5C are schematic cross-sectional views illustrating a method of manufacturing a reflective pattern and an etching prevention pattern according to example embodiments;
FIGS. 6 to 9 are schematic plan views illustrating an etching prevention pattern having a spiral shape of a display device according to example embodiments;
FIGS. 10 to 15 are schematic plan views illustrating an etching prevention pattern having a mesh shape of a display device according to example embodiments;
FIG. 16 is a schematic exploded perspective view illustrating an electronic device according to example embodiments;
FIG. 17 is a schematic view illustrating an electronic device according to example embodiments;
FIG. 18 is a block diagram illustrating components of an electronic device according to an embodiment; and
FIGS. 19 and 20 are schematic views illustrating electronic devices according to various embodiments.

### DETAILED DESCRIPTION

Hereinafter, embodiments of the present disclosure will be described in more detail with reference to the accompanying drawings. In embodiments, the same components are denoted by the same reference numerals through the drawings, and redundant descriptions of the same components may not be repeated. The embodiments disclosed in the accompanying drawings are for illustrative purposes only, and it should be understood that the present disclosure encompasses all modifications, equivalents and substitutes falling within the technical scope thereof.

As used herein, the terms "placed on," "disposed," "overlapped," "connected," "coupled," and/or the like, include not only direct placement, connection or coupling of components, but also embodiments where another component is interposed between the components.

The terms "first", "second", "third", "below", "lower side", "under", "above", "upper side", "over", "left side", "right side", and/or the like are used as relative concepts to distinguish different configurations or positions, and do not indicate absolute positions or order.

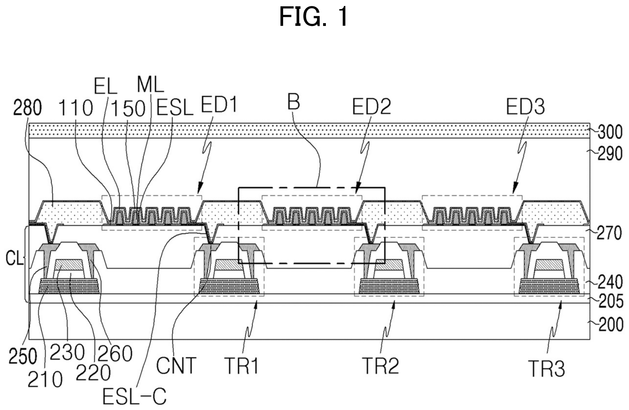

FIG. 1 is a schematic cross-sectional view illustrating a display device according to example embodiments.

Referring to FIG. 1, the display device may include a circuit layer CL on a base substrate 200, and light-emitting devices ED1, ED2 and ED3 on the circuit layer CL.

The base substrate 200 may be provided as a support substrate and/or a back-plane substrate of an image display device. A glass substrate and/or a plastic substrate (e.g., a polymer substrate) may be used as the base substrate 200.

In some embodiments, the base substrate 200 may include a polymeric material having transparency and flexibility. In embodiments, the base substrate 200 may be employed in a transparent flexible display device. For example, the base substrate 200 may include a polymeric material such as polyimide, polysiloxane, epoxy resin, acrylic resin, and/or polyester. In one embodiment, the base substrate 200 may include polyimide.

The circuit layer CL may include transistors TR1, TR2 and TR3. The circuit layer CL may include wiring layers and insulation layers (e.g., electrical insulation layers), which form a thin-film transistor (TFT) array.

The circuit layer CL may further include a buffer layer 205 on an upper surface of the base substrate 200. The buffer layer 205 may block or reduce penetration of moisture through the base substrate 200, and prevent or reduce the diffusion of impurities between the base substrate 200 and the structure formed on the base substrate 200.

The buffer layer 205 may include, for example, silicon oxide, silicon nitride, and/or silicon oxynitride. These materials may be used alone or in combination of two or more thereof. In some embodiments, the buffer layer 205 may have a stacked structure including a silicon oxide film and a silicon nitride film.

The transistors TR1, TR2 and TR3 may be on the buffer layer 205. A first transistor TR1, a second transistor TR2, and a third transistor TR3 may be electrically connected to a first light-emitting device ED1, a second light-emitting device ED2, and a third light-emitting device ED3, respectively.

The transistors TR1, TR2 and TR3 may include an active layer 210, a gate insulation layer 220 and a gate electrode 230, respectively.

The active layer 210 is on the buffer layer 205, and may be repeatedly and regularly provided for each pixel. The active layer 210 may include a silicon compound such as amorphous silicon or polysilicon. Some regions of the active layer 210 may be doped with a p-type dopant or an n-type dopant, and the active layer 210 may include a source region, a drain region and a channel region.

The active layer 210 may include an oxide semiconductor such as indium gallium zinc oxide (IGZO), zinc tin oxide (ZTO), and/or indium zinc tin oxide (IZTO).

The gate insulation layer 220 is on the active layer 210, and the gate electrode 230 may be stacked on the gate insulation layer 220. As shown in FIG. 1, the gate insulation layer 220 may be patterned in a shape that partially covers each active layer 210. In embodiments, the gate insulation layer 220 may extend continuously across a plurality of pixels or light-emitting regions, and may be commonly shared among the first to third transistors TR1, TR2 and TR3.

The gate electrode 230 may be overlapped with the channel region of the active layer 210 in a vertical direction.

An interlayer insulation layer 240, which covers the gate insulation layer 220 and the gate electrode 230, may be on the active layer 210. Connection electrodes 250 and 260, which are in contact with or electrically connected to the active layer 210, may be on the interlayer insulation layer 240.

The connection electrodes 250 and 260 may penetrate the interlayer insulation layer 240, and be connected to the active layer 210. If (e.g., when) the gate insulation layer 220 is commonly and continuously provided across a plurality of light-emitting regions, the connection electrodes 250 and 260 may also penetrate the gate insulation layer 220 together.

The connection electrodes 250 and 260 may include a source electrode 250 which is connected to or in contact with the source region of the active layer 210, and a drain electrode 260 which is connected to or in contact with the drain region of the active layer 210.

The gate insulation layer 220 and the interlayer insulation layer 240 may include silicon oxide, silicon nitride, and/or silicon oxynitride, and may have a stacked structure including a silicon oxide film and a silicon nitride film.

The gate electrode 230 and the connection electrodes 250 and 260 may include metals such as Ag, Mg, Al, W, Cu, Ni, Cr, Mo, Ti, Pt, Ta, Nd, Sc, an alloy thereof, and/or a nitride thereof.

A via insulation layer 270 may be on the interlayer insulation layer 240 to cover the connection electrodes 250 and 260.

The via insulation layer 270 may accommodate a via structure which electrically connects a first electrode 110 and the source electrode 250. The via insulation layer 270 may be provided as a planarization film of the circuit layer CL. In some embodiments, the via insulation layer 270 may include an organic material such as polyimide, an epoxy resin, an acrylic resin, and/or polyester.

The light-emitting devices ED1, ED2 and ED3 may be on the via insulation layer 270. For example, as described with reference to FIG. 1, the light-emitting devices ED1, ED2 and ED3 may include the first electrode 110, a light-emitting layer EL and a second electrode 150, which are stacked in this order on the via insulation layer 270.

The first electrode 110 may be electrically connected to the transistors TR1, TR2 and TR3 or the connection electrodes 250 and 260, which are included in the circuit layer CL, through the via structure. As shown in FIG. 1, the first electrode 110 may be in contact with or connected to the source electrode 250, and be provided as a patterned pixel electrode for each light-emitting region or pixel region.

The pixel electrode may be provided as an anode, and may include a conductive material with a high work function, which facilitates hole injection. The pixel electrode may be provided as a transmissive electrode. The pixel electrode may include a transparent conductive oxide such as indium tin oxide (ITO), indium zinc oxide (IZO), zinc oxide (ZnO), indium tin zinc oxide (ITZO), and/or the like.

The pixel electrode may also be provided as a semi-transmissive electrode or a reflective electrode. The pixel electrode may include metals selected from Ag, Mg, Cu, Al, Pt, Pd, Au, Ni, Nd, Ir, Cr, Li, Ca, LiF, Mo, Ti, W, In, Sn, Zn, or an alloy of two or more thereof.

The pixel electrode may have a single-layer structure or multi-layer structure. For example, the pixel electrode may have a three-layer structure consisting of ITO/Ag/ITO.

A pixel defining layer 280 may be formed on the via insulation layer 270 to define the light-emitting region or pixel region. For example, the pixel defining layer 280 may separate and define a red light-emitting region, a green light-emitting region and a blue light-emitting region, with the light-emitting devices ED1, ED2 and ED3 corresponding to the red light-emitting device, the green light-emitting device, and the blue light-emitting device, respectively.

The pixel defining layer 280 may partially cover the first electrode 110 of each light-emitting region.

As shown in FIG. 1, the light-emitting layer EL may be selectively formed as separate layers between pixel defining layers 280. In some embodiments, the light-emitting layer EL may be continuously over or formed over the pixel defining layer 280, thereby being commonly and continuously provided or placed across the plurality of light-emitting regions or pixel regions.

A hole transport region may be on a lower surface of the light-emitting layer EL, and an electron transport region may be formed on an upper surface of the light-emitting layer EL. In some embodiments, the hole transport region and the electron transport region may be commonly and continuously on or commonly and continuously formed on the pixel defining layer 280 and the plurality of first electrodes 110.

The second electrode 150 may be provided as a common electrode continuously across or formed continuously across the plurality of light-emitting regions or pixel regions.

The common electrode may be provided as an electron injection electrode or a cathode. The common electrode may include a metal, alloy, electrically conductive compound, and/or the like having a low work function.

For example, the common electrode may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, and/or the like. These may be used alone or in combination of two or more thereof.

The common electrode may be provided as a transmissive electrode, semi-transmissive electrode, or reflective electrode. The common electrode may have a single-layer structure or multi-layer structure.

An encapsulation layer 290 may be on the pixel defining layer 280 and the light-emitting devices ED1, ED2 and ED3 to protect the light-emitting devices ED1, ED2 and ED3 from moisture and/or oxygen. The encapsulation layer 290 may be formed as a thin film encapsulation (TFE) layer having a single-layer or multi-layer structure.

The encapsulation layer 290 may include an inorganic film including silicon nitride (SiNx), silicon oxide (SiOx), indium tin oxide, indium zinc oxide, or any suitable combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (e.g., polymethyl methacrylate, polyacrylic acid, and/or the like), an epoxy resin (e.g., aliphatic glycidyl ether (AGE), and/or the like), or any suitable combination thereof; or a combination of both an inorganic film and an organic film.

The display device may further include a functional layer 300 on the encapsulation layer 290. The functional layer 300 may include a sensor layer such as a touch sensor layer; and/or an optical layer such as a polarization layer, a color conversion layer, and/or a color filter layer.

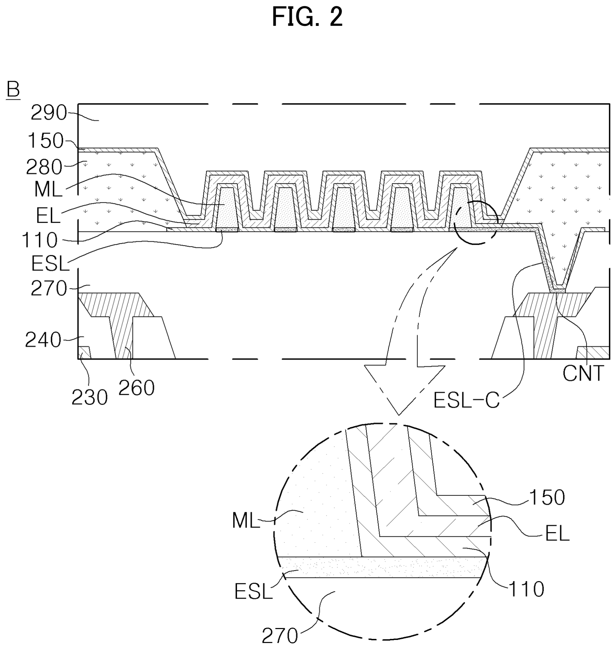

FIG. 2 is a partially enlarged cross-sectional view of region B in FIG. 1.

In some embodiments, the display device may include a reflective pattern ML under the first electrode 110. By including the reflective pattern ML, viewing angle characteristics, for example, viewing angle lateral luminance ratio (LvA) may be improved.

In some embodiments, the reflective pattern ML may include a concave-convex shape including or consisting of an upper surface and an inclined surface. Because the reflective pattern ML has the concave-convex shape, a viewing angle side luminance ratio (LvA) may be enhanced by the inclined surface of the concave and convex portions, and the light efficiency in the front direction may also be improved by the upper surface of the concave and convex portions.

The reflective pattern ML may include, for example, silicon nitride, silicon oxide, and/or the like, in consideration of the refractive index of the upper and lower layer materials.

In some embodiments, the first electrode 110, the light-emitting layer EL and the second electrode 150 may be provided or arranged in a shape corresponding to the shape of the reflective pattern ML.

In some embodiments, an etching prevention pattern ESL may be under the reflective pattern ML. For example, the etching prevention pattern ESL may be on the lower surface of the reflective pattern ML. The reflective pattern ML may be formed using a photolithography method. In embodiments, the via insulation layer 270 on a lower side may be damaged during an etching process to form the reflective pattern ML. To prevent or reduce this phenomenon, the etching prevention pattern ESL may be formed first, followed by forming the reflective pattern ML over the etching prevention pattern ESL.

In example embodiments, the etching prevention pattern ESL may be electrically connected to the first electrode 110. In some embodiments, the etching prevention pattern ESL and the first electrode 110 may be electrically connected by being in direct contact with each other.

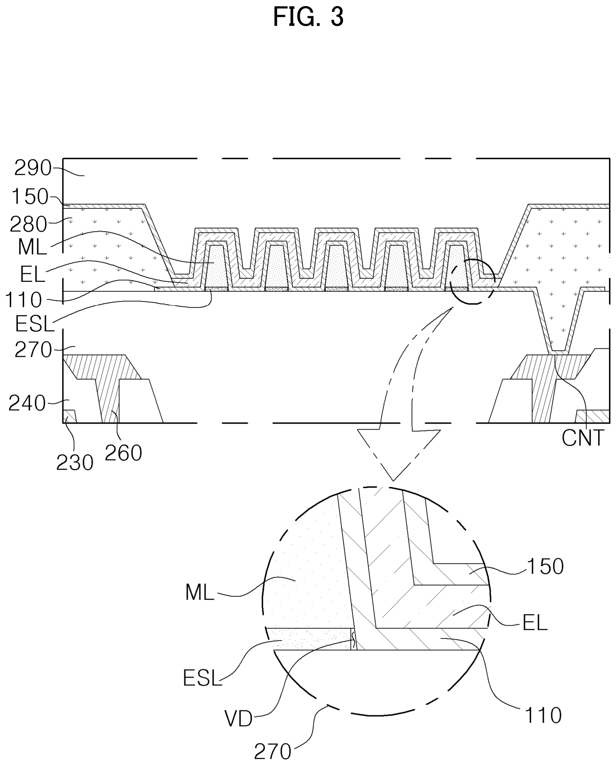

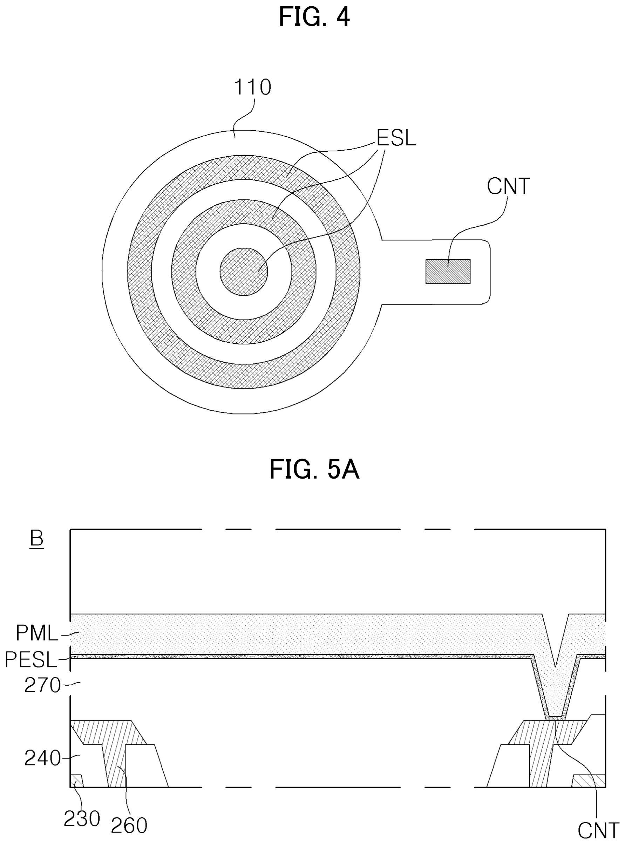

FIGS. 3 and 4 illustrate a comparative example where the etching prevention pattern ESL is not electrically connected to the first electrode 110.

FIG. 3 is a partially enlarged cross-sectional view corresponding to the region of FIG. 2, where the etching prevention pattern ESL is not electrically connected to the first electrode 110. FIG. 4 is a schematic plan view of the etching prevention pattern ESL and the first electrode 110 shown in FIG. 3.

As described above, the etching prevention pattern ESL and the reflective pattern ML may be formed through photolithography method. If wet etching is performed during the photolithography process, isotropic etching occurs due to an etchant, causing the etching prevention pattern ESL beneath the reflective pattern ML to be further etched, thereby resulting in an undercut phenomenon. Accordingly, as shown in FIG. 3, the etching prevention pattern ESL is etched further inward than a bottom edge of the reflective pattern ML, and thus a void space VD is created. Consequently, even if the reflective pattern ML is designed to be in a size so that its bottom edge is in contact with the first electrode 110, the etching prevention pattern ESL beneath the reflective pattern ML may not be connected to the first electrode 110.

As shown in FIGS. 3 and 4, if the etching prevention pattern ESL is not electrically connected to the first electrode 110, parasitic capacitance may be generated by the etching prevention pattern ESL. For example, if (e.g., when) the display device is driven and an electrical signal is applied to the first electrode 110 and the second electrode 150, parasitic capacitance may be generated between the etching prevention pattern ESL and the first electrode 110. If the parasitic capacitance is generated by the etching prevention pattern ESL, the electrical signal applied to the light-emitting layer EL may be disturbed, leading to a deterioration in light emission uniformity.

As shown in FIG. 2, if (e.g., when) the etching prevention pattern ESL is electrically connected to the first electrode 110, the etching prevention pattern ESL may have the same electrical characteristics as the first electrode 110, thereby preventing or reducing the generation of parasitic capacitance. In some embodiments, the etching prevention pattern ESL may have the same potential (e.g., electrical potential) as the first electrode.

In some embodiments, the etching prevention patterns ESL may be integrally formed as a continuous structure, such that the entire etching prevention pattern ESL has the same electrical characteristics, for example, the same potential (e.g., electrical potential).

In some embodiments, the etching prevention pattern ESL may be suitably or sufficiently conductive (e.g., electrically conductive) to have the same electrical characteristics as the first electrode 110. For example, the etching prevention pattern ESL may include at least one selected from indium tin oxide (ITO), indium zinc oxide (IZO), zinc oxide (ZnO) and indium tin zinc oxide (ITZO). In some embodiments, the etching prevention pattern ESL may be formed of the same material as the first electrode 110.

In some embodiments, the etching prevention pattern ESL may be electrically connected to the first electrode 110 under the reflective pattern ML closest to the pixel defining layer 280. Connecting the etching prevention pattern ESL to the first electrode 110 at this position may minimize or reduce its influence on light emitted from the corresponding pixel. In some embodiments, the etching prevention pattern ESL may be electrically connected to the first electrode 110 by extending from under the reflective pattern ML, closest to the pixel defining layer 280, to under the corresponding pixel defining layer 280, thereby further increasing the reliability of the connection to the first electrode 110 while substantially or significantly reducing its effect on the light emitted from the light-emitting layer EL.

In some embodiments, the etching prevention pattern ESL may extend to a contact part CNT where the first electrode 110 is in contact with the connection electrodes 250 and 260, and may be electrically connected to the first electrode 110 and the connection electrodes 250 and 260. In some embodiments, the etching prevention pattern ESL may cover all or part of the contact part CNT. Covering at least part of the contact part CNT by the etching prevention pattern ESL may further enhance the identity of the electrical properties with the first electrode 110.

In some embodiments, the etching prevention pattern ESL may extend to a contact connection part ESL-C while not extending to the contact part CNT, thus allowing it to be electrically connected to the first electrode 110 without directly contacting the connection electrodes 250 and 260. As a result, the electrical connectivity between the first electrode 110 and the contact part CNT may be enhanced.

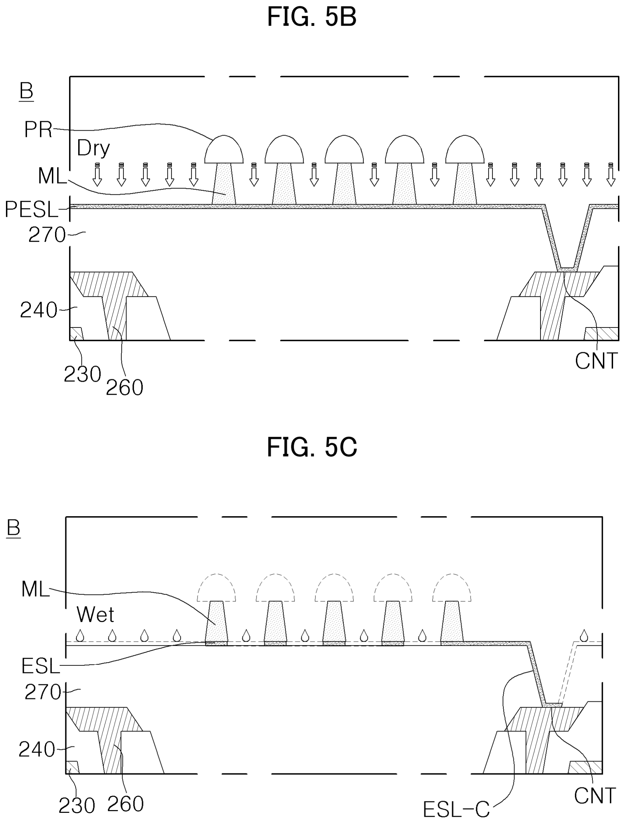

FIGS. 5A, 5B and 5C schematically illustrate a method of manufacturing the reflective pattern ML and the etching prevention pattern ESL according to example embodiments.

An etching prevention pattern forming layer PESL may be formed on the via insulation layer 270, and then a reflective pattern forming layer PML may be formed on an upper surface thereof. The formation of each layer may be performed by a deposition process.

A photoresist PR may be formed in the shape of the reflective pattern ML to be formed on the reflective pattern forming layer PML, and then etched to form the reflective pattern ML. The etching of the reflective pattern forming layer PML may be performed using a wet etching and/or dry etching method, and for example, may be performed using dry etching.

After the reflective pattern ML is formed, the photoresist PR over the reflective pattern ML may be removed, and the etching prevention pattern that forms layer PESL may be etched using the same photolithography method to form the etching prevention pattern ESL. In some embodiments, the etching prevention pattern forming layer PESL may be wet-etched.

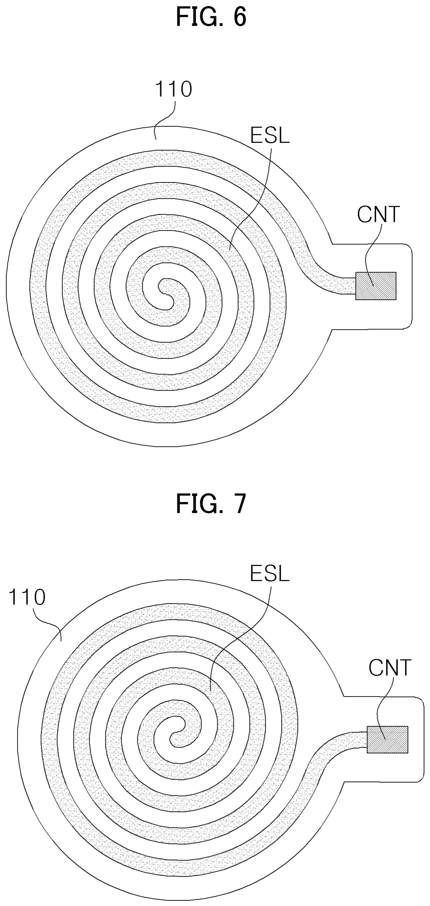

FIGS. 6 to 15 are schematic plan views illustrating a shape of the etching prevention pattern ESL according to example embodiments.

As shown in FIGS. 6 to 9, the etching prevention pattern ESL may include a spiral-shaped pattern. The spiral-shaped pattern may extend in either a clockwise or counterclockwise direction.

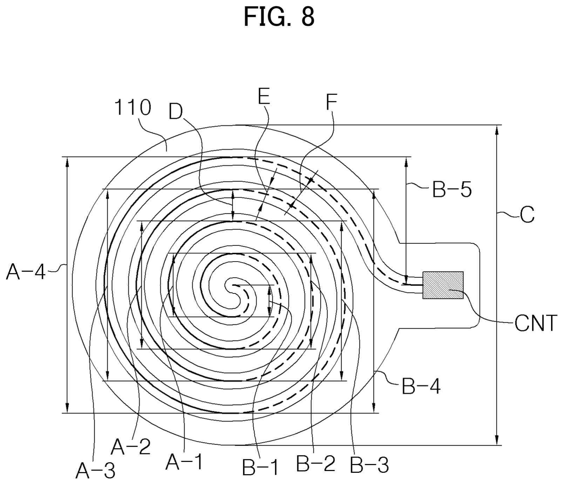

FIG. 8 illustrates a schematic structure of the spiral-shaped pattern according to an embodiment. In some embodiments, the spiral-shaped pattern may have a structure in which semicircles having different diameters are alternately connected based on a spiral center. As shown in FIG. 8, the spiral-shaped pattern may have a structure in which a right semicircle, whose center line is indicated by a dotted line, and a left semicircle, whose center line is indicated by a solid line, are alternately connected.

In some embodiments, the spiral-shaped pattern may have a structure in which semicircles having progressively increasing diameters, starting from a semicircle having the smallest diameter at the spiral center, which serves as a spiral's starting point at one end, are alternately connected. As shown in FIG. 8, a semicircle B-1, which has the smallest diameter and has the spiral's starting point at one end, is connected at its other end to one end of a semicircle A-1. The semicircle A-1 has a larger diameter of circle than that of the semicircle B-1. The other end of semicircle A-1 is connected to one end of semicircle B-2, which has a larger diameter than that of the semicircle A-1. In this manner, semicircles may be alternately connected in the order of B-1/A-1/B-2/A-2/B-3/A-3/B-4/A-4, and their respective diameters may increase in this order.

In some embodiments, an arc B-5 connected to the contact part CNT at the outermost side of the spiral-shaped pattern may have an arc length that is smaller than, equal to, or larger than a semicircle depending on the position of the contact part CNT.

In some embodiments, a set or specific spiral pattern line and a spiral pattern line on an outside thereof may have a distance D between center lines of the spiral pattern lines, which is greater than or equal to a pitch of the spiral pattern line (corresponding to the sum of a line width E of the pattern line and a separation distance F between the pattern lines). In embodiments, the diameter of the corresponding semicircles may gradually increase from the center of the spiral to form the spiral pattern.

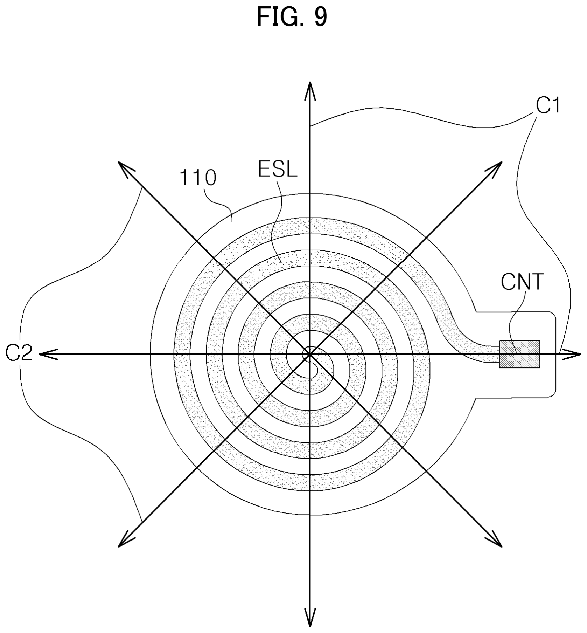

In some embodiments, assuming pairs of symmetry axes that pass through the center of the spiral and are perpendicular to each other ("intersecting symmetry axes"), there may exist a pair of symmetry axes having the same number of pattern lines intersected by each of the intersecting symmetry axes. Referring to FIG. 9, a pair of C1 symmetry axes that are perpendicular (e.g., substantially perpendicular) to each other has the same number of pattern lines intersected by each of the intersecting symmetry axes after the center of the spiral. In embodiments, because the number of pattern lines, intersected by each of the intersecting symmetry axes, is the same, the uniformity of light emitted from the corresponding light-emitting layer EL may be further improved.

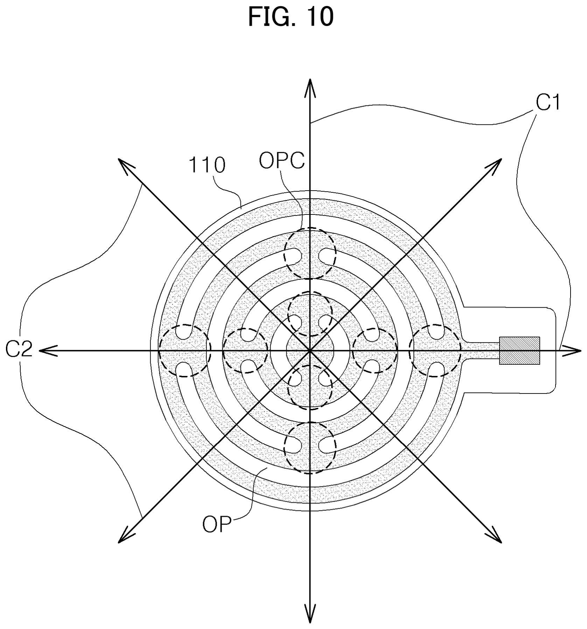

As shown in FIGS. 10 to 15, the etching prevention pattern ESL may include a mesh-shaped pattern.

As shown in FIG. 10, the mesh-shaped pattern may be formed integrally and may have openings OP. In some embodiments, the mesh-shaped pattern may have a contact region OPC where the openings OP face each other, and the contact regions OPC may be formed so that, among pairs of symmetry axes that pass through the center of the mesh-shaped pattern and are perpendicular (e.g., substantially perpendicular) to each other ("intersecting symmetry axes"), there may exist a pair of symmetry axes having the same number of contact regions intersected by each of the intersecting symmetry axes. For example, the pair of symmetry axes C1 has the same number of contact regions intersected by each of the intersecting symmetry axes. In this way, the number of contact regions, intersected by each of the intersecting symmetry axes, is the same, such that the uniformity of light emitted from the corresponding light-emitting layer EL may be further improved.

In some embodiments, assuming a pair of symmetry axes that pass through the center of the mesh-shaped pattern and are perpendicular (e.g., substantially perpendicular) to each other, there may exist a pair of symmetry axes having the same number of openings OP intersected by each of the intersecting symmetry axes. In embodiments, the uniformity of light emitted from the corresponding light-emitting layer EL may be further improved.

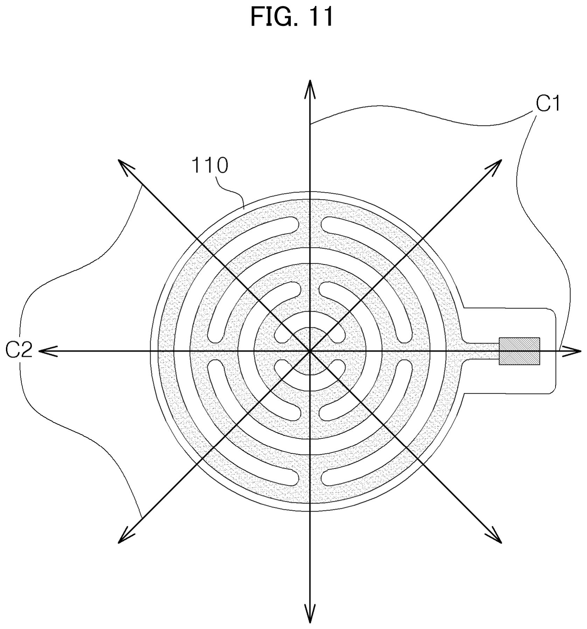

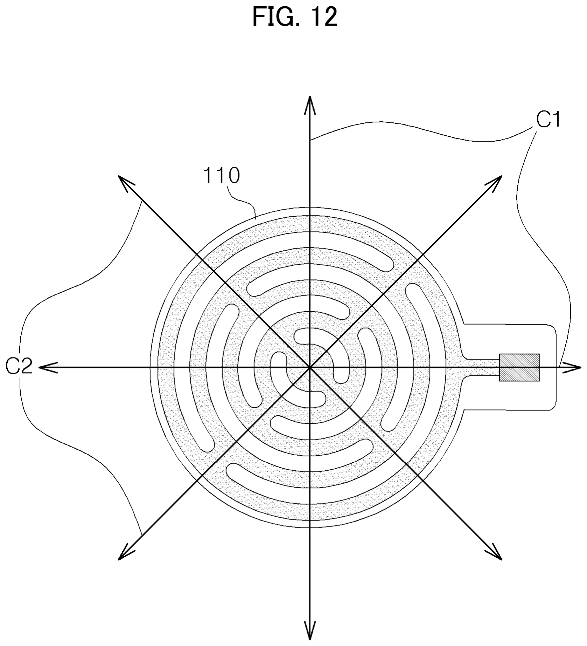

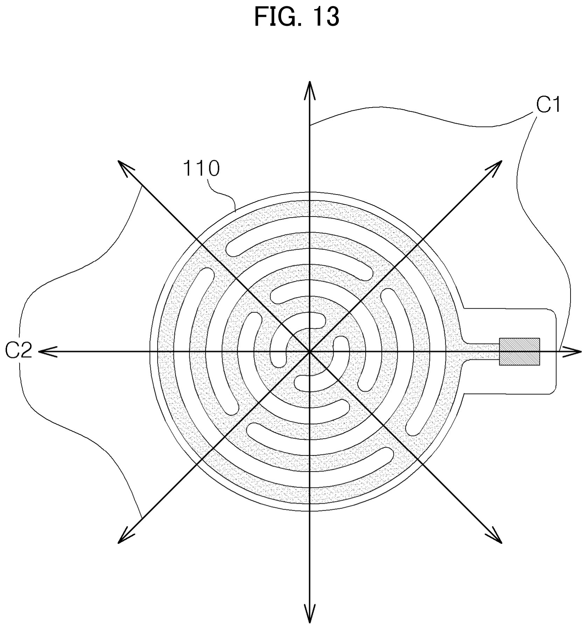

As shown in FIG. 11 to FIG. 13, the mesh-shaped pattern may have various suitable shapes of the opening OP. In some embodiments, there may be suitable variations in which the opening OP is rotated at a set or predetermined angle based on the center of the mesh-shaped pattern. For example, FIG. 11 shows a shape in which the opening OP of the mesh-shaped pattern from FIG. 10 is rotated 90 degrees (°) clockwise based on the center of the pattern. FIGS. 12 and 13 show shapes in which the opening OP of the mesh-shaped pattern from FIG. 10 is rotated 45 degrees (°) counterclockwise and 45 degrees (°) clockwise based on the center of the pattern, respectively.

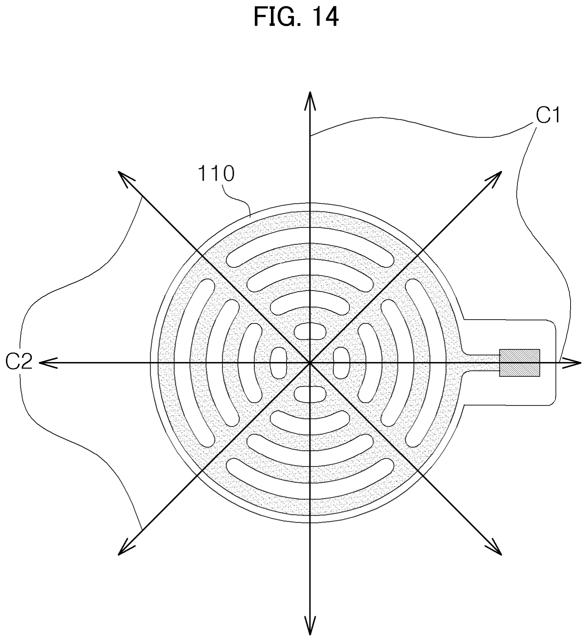

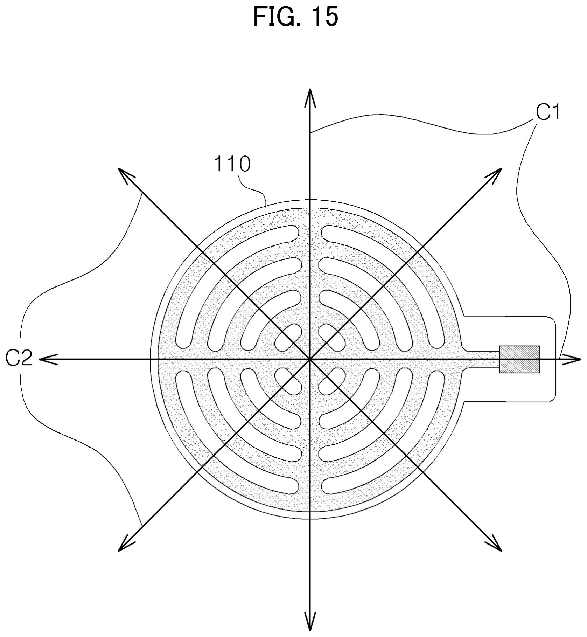

As shown in FIGS. 14 and 15, the mesh-shaped pattern may have openings OP formed in various suitable shapes.

The mesh-shaped patterns shown in FIGS. 11 to 15 may also be formed so that, among the pairs of symmetry axes that pass through the center of the mesh-shaped pattern and are perpendicular (e.g., substantially perpendicular) to each other, there exists a pair of symmetry axes having the same number of openings OP intersected by each of the intersecting symmetry axes. In embodiments, assuming pairs of symmetry axes that pass through the center of the mesh-shaped pattern and are perpendicular (e.g., substantially perpendicular) to each other, there may exist a pair of symmetry axes having the same number of openings OP intersected by each of the intersecting symmetry axes.

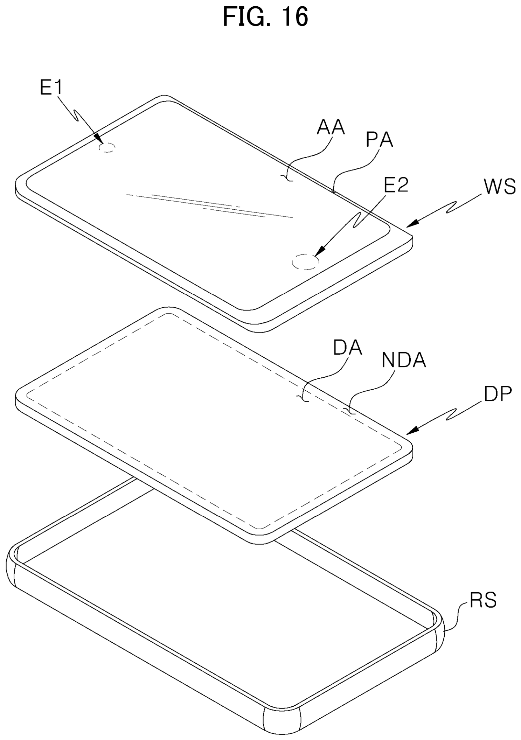

FIG. 16 is a schematic exploded perspective view illustrating an electronic device according to example embodiments.

According to example embodiments, the electronic device may be implemented in the form of a mobile phone (smartphone), tablet, PC, and/or the like, which include the above-described display device.

Referring to FIG. 16, the electronic device may include a window structure WS, a display panel DP and a rear structure RS.

The window structure WS provides an external display surface viewed by a user, such as a visible surface of a mobile phone, and may include a transparent material film. For example, the window structure WS may include glass (e.g., ultra-thin glass (UTG)), a hard coating film, a plastic film, and/or the like.

The window structure WS may include an active area AA and a peripheral area PA formed on an outer surface thereof. The active area AA may provide a surface which substantially displays images of the display device, and receives touch inputs and commands from the user. The peripheral area PA may substantially correspond to a bezel area of the display device.

The display panel DP includes the above-described display device, and may include a display area DA and a non-display area NDA. The display area DA of the display panel DP may substantially correspond to or overlap with the active area AA of the window structure WS. The non-display area NDA of the display panel DP may substantially correspond to or overlap with the peripheral area PA of the window structure WS.

In some embodiments, functional device areas E1 and E2 may be included within the active area AA of the window structure WS. For example, a first functional device area E1 may be included at one end of the active area AA and may be implemented in the form of, for example, a camera hole. A second functional device area E2 may be provided as a fingerprint sensing area.

For example, a sensor structure capable of touch sensing or fingerprint sensing may be provided within the display panel DP, or between the window structure WS and the display panel DP.

The rear structure RS may be provided as a chassis structure or housing of the display device or electronic device. A cover panel may be between the rear structure RS and the display panel DP.

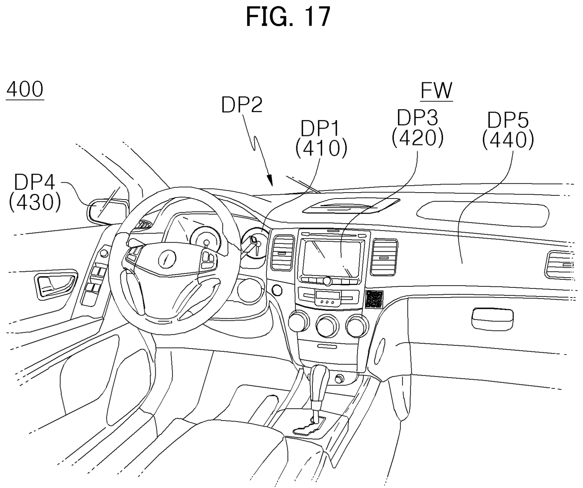

FIG. 17 is a schematic view illustrating an electronic device according to example embodiments.

The electronic device may be installed in, embedded in, attached to, and/or integrally formed with a vehicle 400. The vehicle 400 of embodiments is not limited to the structure shown in FIG. 17, and may include various suitable means of transportation, such as three- or four-wheeled vehicles, construction equipment, two-wheeled vehicles, motorized devices, bicycles, trains, and/or the like. In embodiments, the vehicle 400 may include electric vehicles, hybrid vehicles, and/or the like.

Referring to FIG. 17, at least one selected from first to fifth display devices DP1, DP2, DP3, DP4 and DP5 may be applied to the vehicle 400.

According to example embodiments, the first display device DP1 may be provided in a cluster area 410. In the cluster area 410, driving information such as mileage and/or speed, and/or various suitable warning lights may be displayed.

The second display device DP2 may be provided on a front window FW of the vehicle 400. For example, the second display device DP2 may be provided in the form of a head-up display (HUD).

The third display device DP3 may be provided in a center fascia 420 of the vehicle 400. The center fascia 420 may display buttons and/or switches to control operations of a video/audio player, an air conditioner, a heater, and/or the like, as well as vehicle information.

The fourth display device DP4 may be integrated into a side mirror 430 of the vehicle 400. The side mirrors 430 may be on two (e.g., both) sides of the inside and/or outside of the vehicle, respectively, and the fourth display device DP4 may be applied to at least one of the side mirrors 430 of the two (e.g., both) sides.

The fifth display device DP5 may be provided on a passenger dashboard 440. Information/images which are the same as or different from those displayed in a cluster area 410 and/or the center fascia 420 may be displayed through the passenger dashboard 440.

In some embodiments, the electronic device may be, for example, at least one selected from a flat panel display, a curved display, a computer monitor, a medical monitor, a television, a billboard, indoor and/or outdoor lighting, signaling lights, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a microdisplay, a 3D display, a virtual reality display, an augmented reality display, a vehicle, a video wall composed of a plurality of tiled displays, a theater and/or stadium screen, a light therapy device, and a signage display.

The display device according to the embodiments may be applied to various suitable electronic devices. The electronic device according to the embodiment includes the above-described display device, and may further include a module and/or device having additional functions in addition to the display device.

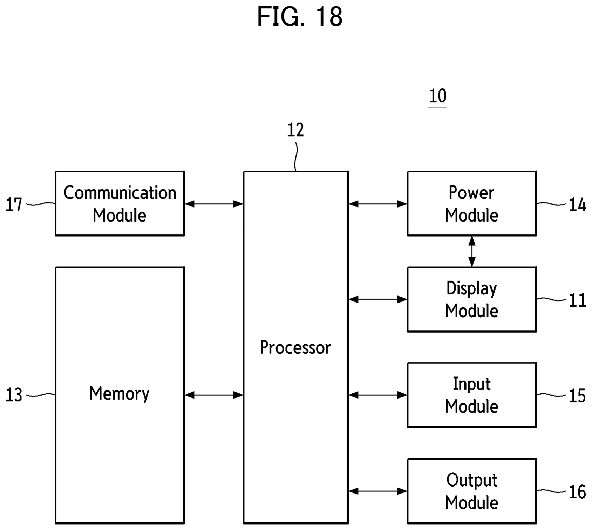

FIG. 18 is a block diagram illustrating components of an electronic device according to an embodiment. Referring to FIG. 18, an electronic device 10 according to an embodiment may include a display module 11, a processor 12, a memory 13 and a power module 14.

The processor 12 may include at least one selected from a central processing unit (CPU), an application processor (AP), a graphic processing unit (GPU), a communication processor (CP), an image signal processor (ISP), and a controller.

The memory 13 may store data information necessary or useful for an operation of the processor 12 or the display module 11. If (e.g., when) the processor 12 executes an application stored in the memory 13, an image data signal and/or an input control signal may be transmitted to the display module 11, and then, the display module 11 may process the received signal and output image information through the display screen.

The power module 14 may include a power supply module such as a power adapter and/or a battery device, and a power conversion module that converts power supplied by the power supply module to generate power necessary or useful for an operation of the electronic device 10.

At least one of the above-described components of the electronic device 10 may be included in the display device according to the embodiments described above. In embodiments, some parts of individual modules functionally integrated in a single module may be included in the display device, while other parts may be provided separately from the display device. For example, the display device may include the display module 11, whereas the processor 12, memory 13 and power module 14 may be provided as parts of another device within the electronic device 10 rather than the display device.

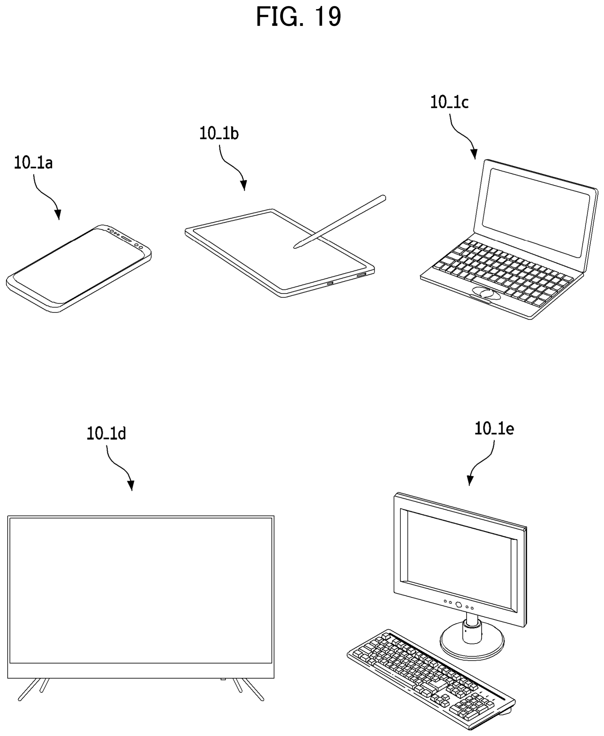

FIG. 19 is a schematic view of an electronic device according to various suitable embodiments.

Referring to FIG. 19, various suitable electronic devices to which the display device according to the embodiments is applied may include not only image display electronic devices such as a smartphone 10_1a, a tablet PC 10_1b, a laptop 10_1c, a TV 10_1d, a desktop monitor 10_1e, and/or the like, but also wearable electronic devices including a display module such as smart glasses, a head-mounted display, a smart watch, and/or the like, and vehicle electronic devices 10_3 including display modules such as a center information display (CID) on an instrument panel, center fascia, and/or dashboard of a vehicle, and/or a room mirror display.

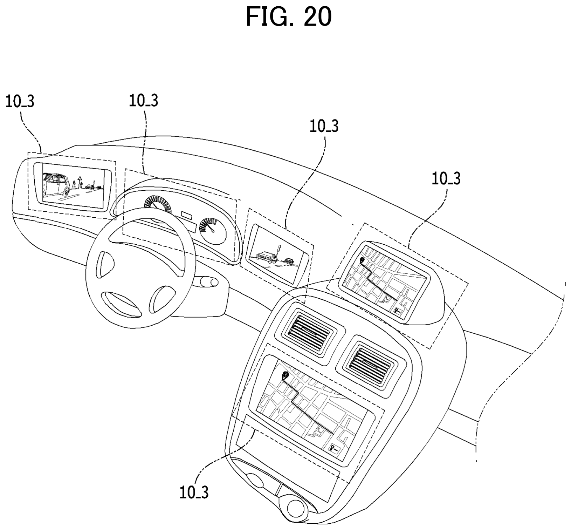

FIG. 20 illustrates a case where an electronic device including the display module is applied to a vehicle as an example. For example, the electronic device 10_3 may be applied to the dashboard, center fascia, and/or the like of the vehicle car, and/or the center information display (CID) on the dashboard of the vehicle, and/or a room mirror display that replaces the side mirror.

As discussed, embodiments of the invention may provide display device a comprising: a pixel defining layer that defines a pixel region; a light-emitting layer provided within the pixel region; a first electrode and a second electrode respectively under and over the light-emitting layer; a reflective pattern under the first electrode; and an etching prevention pattern under the reflective pattern, wherein the etching prevention pattern is electrically connected to the first electrode.

The etching prevention pattern may have the same electrical characteristics, for example, the same potential (e.g., electrical potential) as the first electrode.

In some embodiments, the etching prevention pattern may be formed of the same material as the first electrode.

In some embodiments, the etching prevention pattern and the first electrode may be electrically connected by being in direct contact with each other.

The reflective pattern may overlap portions of the etching prevention pattern.

In some embodiments, the etching prevention pattern may be electrically connected to the first electrode under the reflective pattern at a position adjacent to the pixel defining layer.

In some embodiments, the display device comprises a light-emitting device and a transistor electrically connected to the light-emitting device, wherein the light-emitting device comprises the pixel defining layer, the light-emitting layer, the first electrode, the second electrode, the reflective pattern, and the etching prevention pattern under the reflective pattern; the transistor comprises: an active layer, a gate insulation layer, a gate electrode and a connection electrode, wherein the first electrode and the etching prevention pattern are electrically connected to the connection electrode.

Embodiments may provide an electronic device comprising the display device of any of the above discussed embodiments.

## Claims

1. A display device comprising:
a pixel defining layer that defines a pixel region;
a light-emitting layer provided within the pixel region;
a first electrode and a second electrode respectively under and over the light-emitting layer;
a reflective pattern under the first electrode; and
an etching prevention pattern under the reflective pattern,
wherein the etching prevention pattern is electrically connected to the first electrode.

2. The display device according to claim 1, wherein the etching prevention pattern is arranged to have the same potential as the first electrode;
optionally wherein the etching prevention pattern is formed of the same material as the first electrode.

3. The display device according to claims 1 or 2, wherein the reflective pattern has a concave-convex shape having an upper surface and an inclined surface.

4. The display device according to claim 3, wherein the first electrode, the light-emitting layer and the second electrode are provided in a shape corresponding to the shape of the reflective pattern.

5. The display device according to any one of claims 1 to 4, wherein the etching prevention pattern is electrically connected to the first electrode under the reflective pattern closest to the pixel defining layer.

6. The display device according to any one of claims 1 to 5, wherein the etching prevention pattern has a spiral-shaped pattern when considered in plan view.

7. The display device according to claim 6, wherein the spiral-shaped pattern has a structure in which semicircles having different diameters are alternately connected based on a spiral center.

8. The display device according to claim 7, wherein, among pairs of symmetry axes that pass through the center of the spiral and are perpendicular to each other, there exists a pair of symmetry axes having the same number of pattern lines intersected by each of the intersecting symmetry axes.

9. The display device according to any one of claims 1 to 8, wherein the etching prevention pattern has a mesh-shaped pattern.

10. The display device according to claim 9, wherein the mesh-shaped pattern has a contact region where openings face each other, and
the contact regions are formed so that, among pairs of symmetry axes that pass through a center of the mesh-shaped pattern and are perpendicular to each other, there exists a pair of symmetry axes having the same number of the contact regions intersected by each of the intersecting symmetry axes.

11. The display device according to any one of claims 1 to 10, comprising:
a light-emitting device and a transistor electrically connected to the light-emitting device,
wherein the light-emitting device comprises the pixel defining layer, the light-emitting layer, the first electrode, the second electrode, the reflective pattern, and the etching prevention pattern under the reflective pattern;
wherein the transistor comprises:
an active layer, a gate insulation layer, a gate electrode and a connection electrode,
wherein the first electrode and the etching prevention pattern are electrically connected to the connection electrode.

12. The display device according to claim 11, wherein the etching prevention pattern extends to a contact part of the first electrode and the connection electrode.

13. The display device according to claims 11 or 12, wherein the etching prevention pattern is in contact with at least a part of the contact part of the first electrode and the connection electrode.

14. An electronic device comprising:
the display device according to any one of claims 1 to 13;
a window structure configured to provide a display surface of the display device; and
a housing in which the display device is accommodated.

15. The electronic device according to claim 14, wherein the electronic device comprises a flat panel display, a curved display, a computer monitor, a medical monitor, a television, a billboard, indoor and/or outdoor lighting, a signaling light, a head-up display, a transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a microdisplay, a 3D display, a virtual reality display, an augmented reality display, a vehicle, a video wall, a theater and/or stadium screen, and/or a light therapy device.
